# EUROPEAN PATENT APPLICATION

(11) **EP 4 810 975 A1**
(43) Date of publication of application: **23.09.2026**
(21) Application number: 25898764.3
(22) Date of filing: 06.08.2025
(51) Int. Cl.: G01R 31/385, G01R 1/20, G01R 15/14, G01R 1/30, G01R 19/10, G01R 19/165

(54) **DEVICE AND METHOD FOR MEASURING CURRENT OF BATTERY DEVICE**

(30) Priority: 28.11.2024 KR 20240173609
(71) Applicant: LG Energy Solution, Ltd., Seoul 07335 (KR)
(72) Inventor: JEONG, Dooho, Daejeon 34122 (KR)
(74) Representative: Goddar, Heinz J.
(86) International application number: PCT/KR2025/011789
(87) International publication number: WO 2026/116671

(57) **Abstract**

In a battery management system, a first operational amplifier amplifies a difference between a voltage of a first terminal of a shunt resistor and a voltage of a second terminal of the shunt resistor based on a first gain to output a first output voltage, and a second operational amplifier amplifies the difference between the voltage of the first terminal of the shunt resistor and the voltage of the second terminal of the shunt resistor based on a second gain lower than the first gain to output a second output voltage. A comparison circuit compares the first output voltage with one or more reference voltages to output a selection signal, and a multiplexer selects an output voltage from among the first output voltage and the second output voltage based on the selection signal and outputs the selected output voltage as a measurement voltage corresponding to the current flowing through the shunt resistor.

## Description

### [Technical Field]

### CROSS-REFERENCE TO RELATED APPLICATION

This application claims priority to and the benefit of Korean Patent Application No. 10-2024-0173609 filed in the Korean Intellectual Property Office on November 28, 2024, the entire contents of which are incorporated herein by reference.

The disclosure relates to an apparatus and method for measuring a current in a battery apparatus.

### [Background Art]

Electric vehicles or hybrid vehicles are vehicles that obtain power by driving a motor mainly using a battery as a power source, and are being actively researched because they are alternatives that can solve pollution and energy problems of internal combustion vehicles. Further, batteries are used in various external apparatuses other than the electric vehicles.

To measure a current of a battery, a shunt current sensor may be used. The shunt current sensor may measure a voltage across a shunt resistor in a current path using an operational amplifier. In this case, a gain of the operational amplifier may be set in consideration of a current range. However, as various outputs are required from the battery, currents of various ranges may be output from the battery. Therefore, if the gain of the operational amplifier is set low in consideration of a high range of current, an output voltage of the operational amplifier may become low in a low range of current, making it vulnerable to noise. If the gain of the operational amplifier is set high in consideration of the low range of current, there is a problem that the output voltage of the operational amplifier becomes too high in the high range of current.

### [Disclosure]

### [Technical Problem]

Some embodiments may provide an apparatus and method for measuring a current, capable of measuring currents in various ranges in a battery apparatus.

### [Technical Solution]

According to some embodiments, a battery management system of a battery apparatus including a battery module and a shunt resistor through which a current of the battery module flows may be provided. The battery management system may include a first operational amplifier configured to amplify a difference between a voltage of a first terminal of the shunt resistor and a voltage of a second terminal of the shunt resistor based on a first gain to output a first output voltage, a second operational amplifier configured to amplify the difference between the voltage of the first terminal of the shunt resistor and the voltage of the second terminal of the shunt resistor based on a second gain lower than the first gain to output a second output voltage, a comparison circuit configured to compare the first output voltage with one or more reference voltages to output a selection signal, and a multiplexer configured to select an output voltage from among the first output voltage and the second output voltage based on the selection signal and to output the selected output voltage as a measurement voltage corresponding to the current flowing through the shunt resistor.

A battery apparatus according to some embodiments may include a battery module, a shunt resistor through which a current of the battery module flows, a current measurement apparatus configured to generate a first output voltage corresponding to the current flowing through the shunt resistor based on a first gain, generate a second output voltage corresponding to the current flowing through the shunt resistor based on a second gain different from the first gain, and select, as a measurement voltage, an output voltage from among a plurality of output voltages including the first output voltage and the second output voltage based on the first output voltage, and a processor configured to determine the current flowing through the shunt resistor based on the measurement voltage of the current measurement apparatus.

A method of measuring a current of a battery apparatus according to some embodiments may include receiving voltages of a first terminal and a second terminal of a shunt resistor formed in a path through which a current of a battery module flows, amplifying a voltage between the first terminal and the second terminal based on a first gain to generate a first output voltage, amplifying the voltage between the first terminal and the second terminal based on a second gain different from the first gain to generate a second output voltage, and measuring the current flowing through the resistor based on the second output voltage in response to the first output voltage satisfying a predetermined condition.

### [Description of the Drawings]

FIG. 1 is a block diagram of a battery apparatus according to some embodiments.
FIG. 2 is a diagram illustrating a current measurement apparatus of a battery apparatus according to some embodiments.
FIG. 3 is a diagram illustrating an operational amplifier circuit of a current measurement apparatus according to some embodiments.
FIG. 4 is a diagram illustrating a comparison circuit of a current measurement apparatus according to some embodiments.
FIG. 5 is a diagram illustrating a multiplexer of a current measurement apparatus according to some embodiments.
FIG. 6 is a flowchart illustrating a current measurement method of a battery apparatus according to some embodiments.

### [Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

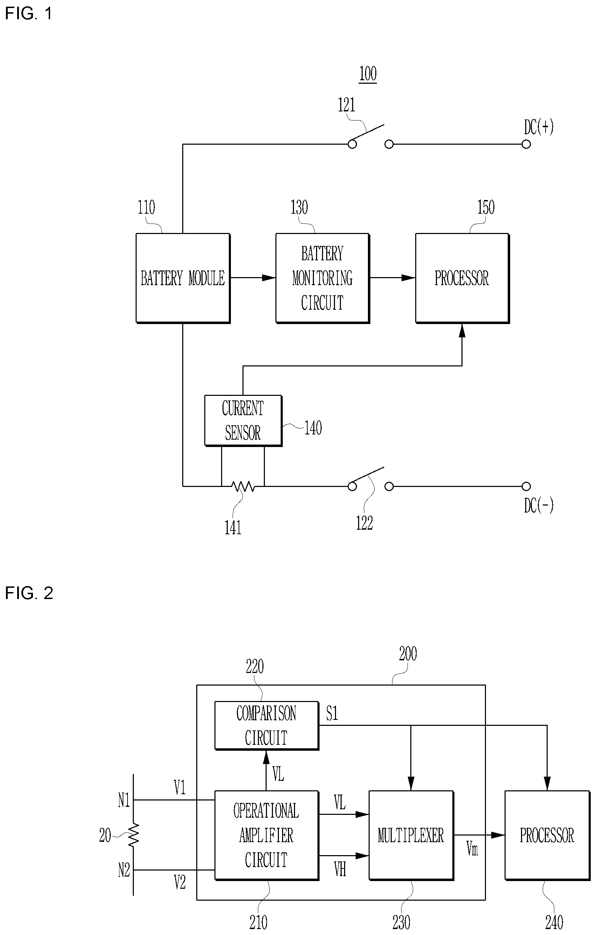

FIG. 1 is a block diagram of a battery apparatus according to some embodiments.

Referring to FIG. 1, a battery apparatus 100 has a structure that can be electrically connected to an external device through a positive link terminal DC(+) and a negative link terminal DC(-). In some embodiments, when the external device is a load, the battery apparatus 100 may be discharged by operating as a power source that supplies power to the load. When the external device is a charger, the battery apparatus 100 may be charged by being supplied with external power through the charger. In some embodiments, the external device operating as the load may be, for example, an electronic device, a mobility device, or an energy storage system (ESS), and the mobility device may be, for example, a vehicle such as an electric vehicle, a hybrid vehicle, or smart mobility.

The battery apparatus 100 may include a battery module 110, a positive switch 121, a negative switch 122, a battery monitoring circuit 130, a current measurement apparatus 140, and a processor 150. In some embodiments, the battery apparatus 100 may include a battery management system, and the battery management system may include the battery monitoring circuit 130, the current measurement apparatus 140, and the processor 150. The battery apparatus 100 may be referred to as a battery pack.

The battery module 110 may include a plurality of battery cells (not shown) connected in series. In some embodiments, the battery cell may be a rechargeable battery. In some embodiments, a plurality of battery modules 110 may be connected in series or parallel to supply desired power. The battery module 110 may be connected to link terminals DC(+) and DC(-) of the battery apparatus 100 through the positive switch 121 and the negative switch 122.

The positive switch 121 may be connected between a positive terminal of the battery module 110 and a positive link terminal DC(+) of the battery apparatus 100. The negative switch 122 may be connected between a negative terminal of the battery module 110 and a negative link terminal DC(-) of the battery apparatus 100. The switches 121 and 122 may be controlled by the processor 150 to control the connection between the battery module 110 and the external device 10. In some embodiments, the switches 121 and 122 may each include a contactor including a relay. In some embodiments, the switches 121 and 122 may each include an electrical switch such as a transistor. In some embodiments, the battery apparatus 100 may further include a driving circuit (not shown) that drives each of the switches 121 and 122 in response to a control signal from the processor 150. When the positive switch 121 and the negative switch 122 are closed, power may be supplied from the battery module 110 to the external device 10, or power may be supplied from the external device 10 to the battery module 110.

The battery monitoring circuit 130 may be connected to the battery module 110, and may be connected to each of a plurality of battery cells included in the battery module 110 to monitor the state of the battery cells (e.g., cell voltage) and/or the state of the battery module 110 (e.g., voltage, temperature, and/or charge capacity of the battery module 110). In some embodiments, the battery monitoring circuit 130 may include a battery monitoring IC (BMIC) provided as an IC (integrated circuit).

The current measurement apparatus 140 may be connected to a resistor 141 installed in a path through which a current of the battery module 110 flows, and may measure the current flowing through the battery module 110 based on a voltage across the resistor 141. The current measurement apparatus 140 may be called a current sensor, and the resistor 141 may be called a shunt resistor. In some embodiments, as shown in FIG. 1, the current measurement apparatus 140 may measure the current flowing through the battery module 110 based on the voltage across the resistor 141 connected between a negative terminal of the battery module 110 and the negative link terminal DC(-) of the battery apparatus (or one terminal of the negative switch 122). In some embodiments, the current measurement apparatus 140 may measure the current flowing through the battery module 110 based on the voltage across a resistor (not shown) connected between a positive terminal of the battery module 110 and the positive link terminal DC(+) of the battery apparatus (or one terminal of the positive switch 121).

The processor 150 may control the positive switch 121 and the negative switch 122. The processor 150 may close the positive switch 121 and the negative switch 122 to electrically connect the battery apparatus 100 and the external device 10. The processor 150 may open the positive switch 121 and/or the negative switch 122 to electrically disconnect the battery apparatus 100 and the external device 10. The processor 150 may receive information about the measured cell voltage and temperature from the battery monitoring circuit 130, and may receive information about the measured current from the current measurement apparatus 140. In some embodiments, the processor 150 may be a processing circuitry, for example, a microcontroller unit (MCU).

FIG. 2 is a diagram illustrating a current measurement apparatus of a battery apparatus according to some embodiments.

Referring to FIG. 2, a current measurement apparatus 200 may be connected to a resistor 20 of a battery apparatus. In some embodiments, the resistor 20 may be formed in a path through which a current of a battery module (e.g., 110 in FIG. 1) flows. In some embodiments, the resistor 20 may be connected between a negative terminal of the battery module 110 and a negative link terminal of the battery apparatus (e.g., DC(-) in FIG. 1) (or one terminal of a negative switch (e.g., 122 in FIG. 1)). In some embodiments, the resistor 20 may be connected between a positive terminal of the battery module 110 and a positive link terminal of the battery apparatus (e.g., DC(+) in FIG. 1) (or one terminal of a positive switch (e.g., 121 in FIG. 1)).

The current measurement apparatus 200 may include an operational amplifier circuit 210, a comparison circuit 220, and a multiplexer 230.

The operational amplifier circuit 210 may be connected to both terminals N1 and N2 of the resistor 20 and may receive voltages of both terminals N1 and N2 as input. A plurality of gains may be set in the operational amplifier circuit 210. In some embodiments, the plurality of gains may include a first gain (alternatively, high gain) and a second gain (alternatively, low gain) lower than the first gain. The first gain may be used to measure a current in a low current range, and the second gain may be used to measure a current in a high current range. The operational amplifier circuit 210 may amplify a difference between a voltage of a first terminal N1 and a voltage of a second terminal N2 of the resistor 20 based on each of a plurality of gains, and may output a plurality of output voltages VL and VH that are amplified by the plurality of gains, respectively. The voltage amplified in the operational amplifier circuit 210 may be given, for example, as a voltage obtained by multiplying the difference between the voltage of the first terminal N1 and the voltage of the second terminal N2 of the resistor 20 by each gain. In some embodiments, the operational amplifier circuit 210 may output a first output voltage VL that is amplified based on the first gain from the difference between the voltage of the first terminal N1 and the voltage of the second terminal N2 of the resistor 20, and a second output voltage VH that is amplified based on the second gain from the difference between the voltage of the first terminal N1 and the voltage of the second terminal N2 of the resistor 20.

The comparison circuit 220 may output a selection signal S1 that indicates the output voltage to be selected from the plurality of output voltages VL and VH, based on a magnitude of the current flowing through the resistor 20. In some embodiments, the comparison circuit 220 may determine the magnitude of the current flowing through the resistor 20 based on at least one output voltage among the plurality of output voltages of the operational amplifier circuit 210. That is, the comparison circuit 220 may output the selection signal S1 based on the magnitude of the at least one output voltage (e.g., the first output voltage VL) among the plurality of output voltages of the operational amplifier circuit 210. In some embodiments, the comparison circuit 220 may output the selection signal S1 having a predetermined level in cases that the magnitude of the first output voltage VL is higher than a first threshold voltage or lower than a second threshold voltage. In cases that the current flowing through the resistor 20 belongs to a high current range, the first output voltage VL may become higher than the first threshold voltage or lower than the second threshold voltage, so the comparison circuit 220 may output the selection signal S1 having the predetermined level.

The multiplexer 230 may receive the plurality of output voltages VL and VH from the operational amplifier circuit 210, and may output one output voltage among the plurality of output voltages VL and VH as a measurement voltage Vm based on the selection signal S1. In some embodiments, the multiplexer 230 may select the output voltage Vm among the plurality of output voltages VL and VH based on the level of the selection signal S1. In some embodiments, in cases that the selection signal S1 does not have the predetermined level, the multiplexer 230 may select the first output voltage VL and output the first output voltage VL as the measurement voltage Vm. In cases that the selection signal S1 has the predetermined level, the multiplexer 230 may switch a mode to select the second output voltage VH and output the second output voltage VH as the measurement voltage Vm. The multiplexer 230 may switch between a mode for measuring the current in the low current range and a mode for measuring the current in the high current range in response to the selection signal S1. The selection signal S1 may be referred to as a mode switching signal.

A processor 240 may receive the output voltage output from the multiplexer 230 and determine the measured current. In some embodiments, the processor 240 may further receive the selection signal S1. The processor 240 may identify the gain used in the current measurement apparatus 200 based on the level of the selection signal S1, and calculate the measured current based on the identified gain and the output voltage input from the multiplexer 230.

As described above, the current measurement apparatus 200 may measure the current using the high gain in cases that the current flowing through the resistor 20 belongs to the low current range, and measure the current using the low gain in cases that the current flowing through the resistor 20 belongs to the high current range. Therefore, the problem that the output voltage of the current measurement apparatus 200 is vulnerable to noise or becomes too high can be solved.

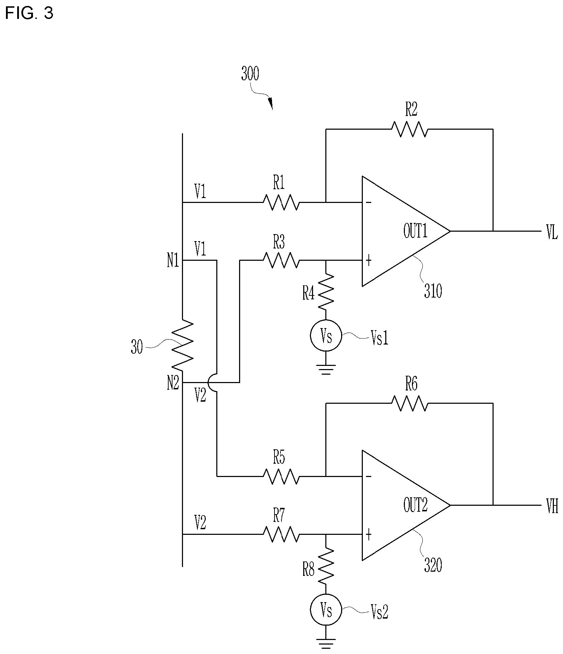

FIG. 3 is a diagram illustrating an operational amplifier circuit of a current measurement apparatus according to some embodiments.

Referring to FIG. 3, an operational amplifier circuit 300 may include operational amplifiers 310 and 320. In some embodiments, the operational amplifier circuit 300 may further include resistors R1, R2, R3, R4, R5, R6, R7, and R8.

The operational amplifier 310 may have a positive input terminal, a negative input terminal, and an output terminal OUT1, and the operational amplifier 320 may have a positive input terminal, a negative input terminal, and an output terminal OUT2.

The negative input terminals of the operational amplifiers 310 and 320 may be connected to one terminal (alternatively, first terminal) N1 of the resistor 30, and may receive a voltage V1 of the first terminal of the resistor 20. The positive input terminals of the operational amplifiers 310 and 320 may be connected to another terminal (alternatively, second terminal) N2 of the resistor 30, and may receive a voltage (V2) of the second terminal of the resistor 30. The operational amplifier 310 may be set to have a first gain, and the operational amplifier 320 may be set to have a second gain lower than the first gain. Then, the operational amplifier 310 may be used to measure a current in a low current range, and the operational amplifier 320 may be used to measure a current in a high current range. The operational amplifier 310 may output a first output voltage VL amplified based on the first gain from the voltage V2-V1 between both terminals N1 and N2 of the resistor 30 to the output terminal OUT1, and the operational amplifier 320 may output a second output voltage VH amplified based on the second gain from the voltage V2-V1 between both terminals N1 and N2 of the resistor 30 to the output terminal OUT2.

In some embodiments, the operational amplifier 310 may be connected in the form of a differential amplifier to have the first gain, and the operational amplifier 320 may be connected in the form of a differential amplifier to have the second gain. A resistor R1 may be connected between the negative input terminal of the operational amplifier 310 and the first terminal N1 of the resistor 30, the resistor R2 may be connected between the negative input terminal of the operational amplifier 310 and the output terminal OUT1 of the operational amplifier 310, the resistor R3 may be connected between the positive input terminal of the operational amplifier 310 and the second terminal N2 of the resistor 30, and the resistor R4 may be connected between the positive input terminal of the operational amplifier 310 and a power source Vs1 that provides a predetermined voltage Vs. Similarly, the resistor R5 may be connected between the negative input terminal of the operational amplifier 320 and the first terminal N1 of the resistor 30, the resistor R6 may be connected between the negative input terminal of the operational amplifier 320 and the output terminal OUT2 of the operational amplifier 320, the resistor R7 may be connected between the positive input terminal of the operational amplifier 320 and the second terminal N2 of the resistor 30, and the resistor R8 may be connected between the positive input terminal of the operational amplifier 320 and a power source Vs2 that provides a predetermined voltage Vs.

In some embodiments, a ratio R2/R1 of resistances of the resistors R1 and R2 and a ratio R4/R3 of resistances of the resistors R3 and R4 may be set to be the same. For example, the resistances of the resistors R1 and R3 may be the same, and the resistances of the resistors R2 and R4 may be the same. In some embodiments, a ratio R6/R5 of resistances of the resistors R5 and R6 and a ratio of resistances of the resistors R7 and R8 may be set to be the same. For example, the resistances of the resistors R5 and R7 may be the same, and the resistances of the resistors R6 and R8 may be the same. In this case, the output voltages VL and VH of the operational amplifiers 310 and 320 may be given as in Equations 1 and 2, respectively. Therefore, a gain (alternatively, first gain) of the operational amplifier 310 may be given as R2/R1, and a gain (alternatively, second gain) of the operational amplifier 320 may be given as R6/R5. $VL = Vs + \frac{R 2}{R 1} \left(V2-V1\right)$ $VH = Vs + \frac{R 6}{R 5} \left(V2-V1\right)$

In some embodiments, the predetermined voltage Vs may be set such that the output voltages VL and VH of the operational amplifiers 310 and 320 have a positive value. For example, it is assumed that the resistance of the resistor R2 is 1 mΩ, the low current range is a range of -20A to 20A, the high current range is a range of -100A to 100A, the first gain R2/R1 is 100, and the second gain R6/R5 is 20. In this case, the predetermined voltage may be set to, for example, 2.5V. Then, in the low current range, the first operational amplifier 310 may output the output voltage VL between 0.5V and 4.5V, and in the high current range, the second operational amplifier 320 may also output the output voltage VH between 0.5V and 4.5V.

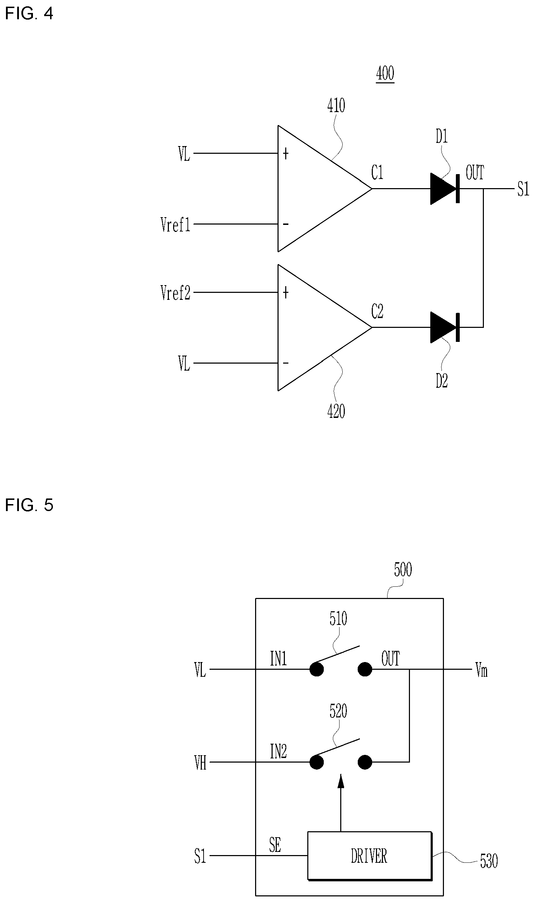

FIG. 4 is a diagram illustrating a comparison circuit of a current measurement apparatus according to some embodiments.

Referring to FIG. 4, a comparison circuit 400 may include comparators 410 and 420.

The comparator 410 may compare an output voltage of one operational amplifier among a plurality of operational amplifiers included in an operational amplifier circuit with a reference voltage (alternatively, a first reference voltage) Vref1. In some embodiments, the comparator 410 may receive an output voltage VL of an operational amplifier (e.g., 310 in FIG. 3) having a high gain among the plurality of operational amplifiers. In some embodiments, the comparator 410 may have a positive input terminal that receives the output voltage VL of the operational amplifier 310 and a negative input terminal that receives the reference voltage Vref1. The comparator 410 may compare the output voltage VL of the operational amplifier 310 with the reference voltage Vref1 and output an output signal C1 according to the comparison result to an output terminal. The comparator 410 may output the output signal C1 having a predetermined level in cases that the output voltage VL of the operational amplifier 310 is higher than the reference voltage Vref1. The predetermined level may be, for example, a high level as a logic level.

The comparator 420 may compare an output voltage of one operational amplifier among a plurality of operational amplifiers included in the operational amplifier circuit with a reference voltage (alternatively, a second reference voltage) Vref2. The second reference voltage Vref2 may be a voltage lower than the first reference voltage Vref1. In some embodiments, the comparator 420 may receive the output voltage VL of the operational amplifier (e.g., 310 in FIG. 3) having the high gain among the plurality of operational amplifiers. In some embodiments, the comparator 420 may have a negative input terminal that receives the output voltage VL of the operational amplifier 310 and a positive input terminal that receives the reference voltage Vref2. The comparator 420 may compare the output voltage VL of the operational amplifier 310 with the reference voltage Vref2 and output an output signal C2 according to the comparison result to an output terminal. The comparator 420 may output the output signal C2 having a predetermined level in cases that the output voltage VL of the operational amplifier 310 is lower than the reference voltage Vref2. The predetermined level may be, for example, a high level as a logic level.

The comparison circuit 400 may output an output signal having a predetermined level (e.g., high level) among the output signal C1 of the comparator 410 and the output signal C2 of the comparator 420 as a final output signal (i.e., a selection signal) S1 at an output terminal OUT. In some embodiments, in order to output the output signal having the predetermined level among the output signal C1 of the comparator 410 and the output signal C2 of the comparator 420 as the selection signal S1, the comparison circuit 400 may further include diodes D1 and D2. An anode of the diode D1 may connected to the output terminal of the comparator 410, and an anode of the diode D2 may be connected to the output terminal of the comparator 420. A cathode of the diode D1 and a cathode of the diode D2 may be connected to the output terminal OUT of the comparison circuit 400.

For example, the first reference voltage Vref1 may be 4.5V, and the second reference voltage Vref2 may be 0.5V. In this case, referring to the example described above, in cases that a current flowing through a resistor (e.g., 20 in FIG. 2) is greater than 20A, an output voltage VL of an operational amplifier (e.g., 310 in FIG. 3) may become higher than 4.5V, so the comparator 410 may output the output signal C1 having the predetermined level. Accordingly, the comparison circuit 400 may output the selection signal S1 having the predetermined level, and the multiplexer (e.g., 230 in FIG. 2) may output an output voltage VH of an operational amplifier (e.g., 320 in FIG. 3) having a low gain in response to the selection signal S1. In addition, in cases that the current flowing through the resistor 20 is smaller than -20A, the output voltage VL of the operational amplifier 310 may become lower than 0.5V, so the comparator 420 may output the output signal C2 having the predetermined level. Accordingly, the comparison circuit 400 may outputs the selection signal S1 having the predetermined level, and the multiplexer 230 may output the output voltage VH of the operational amplifier 320 having the low gain in response to the selection signal S1. In this way, in cases that the current belongs to the high current range outside the range of -20A to 20A, the current may be measured through the operational amplifier 320 having the low gain.

FIG. 5 is a diagram illustrating a multiplexer of a current measurement apparatus according to some embodiments.

Referring to FIG. 5, a multiplexer 500 may have a plurality of input terminals IN1 and IN2 that receive a plurality of output voltages of a plurality of operational amplifiers included in an operational amplifier circuit, respectively, and an output terminal OUT that outputs an output voltage selected from among the plurality of output voltages in response to a selection signal S1. In addition, the multiplexer 500 may have a selection terminal SE that receives the selection signal S1. In some embodiments, the input terminal IN1 may receive an output voltage VL of an operational amplifier (e.g., 310 in FIG. 3) having a high gain, and the input terminal IN2 may receive an output voltage VH of an operational amplifier (e.g., 320 in FIG. 3) having a low gain.

The multiplexer 500 may include a plurality of switches 510 and 520. The switch 510 may be connected between the input terminal IN1 and the output terminal OUT, and the switch 520 may be connected between the input terminal IN2 and the output terminal OUT. In some embodiments, the multiplexer 500 may further include a driver 530 that drives the switches 510 and 520. The driver 530 may drive the switches 510 and 520 in response to the selection signal S1. In some embodiments, in cases that the selection signal S1 has a predetermined level (e.g., a high level), the driver 530 may output a control signal for closing the switch 520 and opening the switch 510, and the multiplexer 500 may output the output voltage VH as a measurement voltage Vm. In cases that the selection signal S1 does not have the predetermined level, the driver 530 may output a control signal for closing the switch 510 and opening the switch 520, and the multiplexer 500 may output the output voltage VL as the measurement voltage Vm.

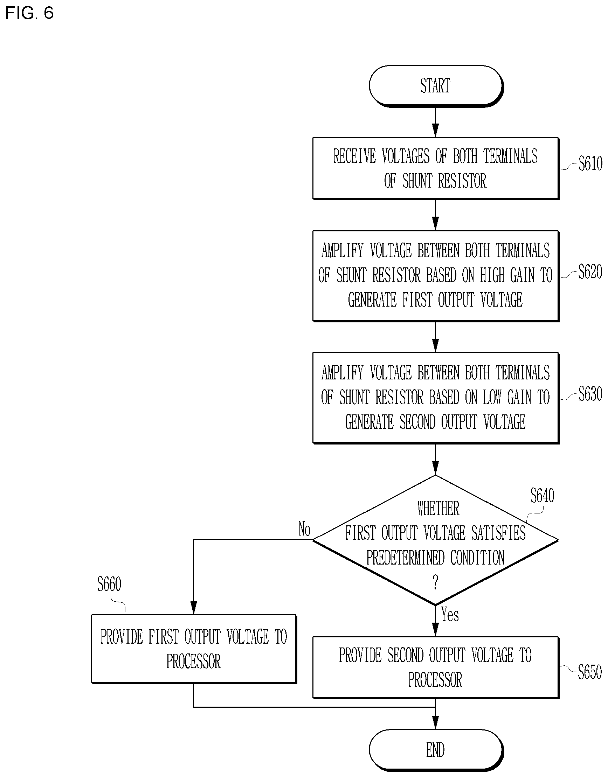

FIG. 6 is a flowchart illustrating a current measurement method of a battery apparatus according to some embodiments.

Referring to FIG. 6, a current measurement apparatus may receive voltages of both terminals of a shunt resistor (e.g., 141 in FIG. 1) formed in a path through which a current of a battery module (e.g., 110 in FIG. 1) flows (S610). The current measurement apparatus may amplify a voltage between both terminals of the resistor 141 based on a high gain (alternatively, a first gain) to generate a first output voltage corresponding to the current flowing through the resistor 141 (S620). In some embodiments, the current measurement apparatus may use a first operational amplifier having the high gain to amplify the voltage between both terminals of the resistor 141 thereby generating the first output voltage (S620). The current measurement apparatus may amplify the voltage between both terminals of the resistor 141 based on a low gain (alternatively, a second gain) to generate a second output voltage corresponding to the current flowing through the resistor 141 (S630). In some embodiments, the current measurement apparatus may use a second operational amplifier having the low gain to amplify the voltage between both terminals of the resistor 141 thereby generating the second output voltage (S630).

In cases that the first output voltage satisfies a predetermined condition (S640: YES), the current measurement apparatus may provide the second output voltage to a processor (e.g., 150 in FIG. 1) (S650). In some embodiments, the predetermined condition may include a condition that the first output voltage is higher than a first reference voltage or lower than a second reference voltage. The second reference voltage may be a voltage lower than the first reference voltage.

While the current measurement apparatus is measuring the current flowing through the resistor 141 based on the first output voltage, in cases that the first output voltage satisfies the predetermined condition, it may measure the current flowing through the resistor 141 based on the first output voltage. In some embodiments, the current measurement apparatus may provide a selection signal (alternatively, a mode change signal) to the processor 150 that indicates a mode of measuring the current with the operational amplifier having the low gain (alternatively, a mode of measuring a current in a high current range) (S650). In cases that the output voltage of the operational amplifier having the high gain does not satisfy the predetermined condition (S640: NO), the current measurement apparatus may provide the first output voltage of the operational amplifier having the high gain to the processor 150 (S660). In some embodiments, the current measurement apparatus may provide the selection signal (alternatively, the mode change signal) to the processor 150 that indicates a mode of measuring the current with the operational amplifier having the high gain (alternatively, a mode of measuring a current in a low current range) (S660).

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A battery management system of a battery apparatus including a battery module and a shunt resistor through which a current of the battery module flows, the battery management system comprising:
a first operational amplifier configured to amplify a difference between a voltage of a first terminal of the shunt resistor and a voltage of a second terminal of the shunt resistor based on a first gain to output a first output voltage;
a second operational amplifier configured to amplify the difference between the voltage of the first terminal of the shunt resistor and the voltage of the second terminal of the shunt resistor based on a second gain lower than the first gain to output a second output voltage;
a comparison circuit configured to compare the first output voltage with one or more reference voltages to output a selection signal; and
a multiplexer configured to select an output voltage from among the first output voltage and the second output voltage based on the selection signal and to output the selected output voltage as a measurement voltage corresponding to the current flowing through the shunt resistor.

2. The battery management system of claim 1, further comprising a processor configured to receive the selection signal and the measurement voltage, and to determine the current flowing through the shunt resistor based on the selection signal and the measurement voltage.

3. The battery management system of claim 2, wherein the processor is configured to:
determine the current flowing through the shunt resistor based on the second gain and the measurement voltage in response to the selection signal having a predetermined level; and
determine the current flowing through the shunt resistor based on the first gain and the measurement voltage in response to the selection signal not having the predetermined level.

4. The battery management system of claim 1, wherein the one or more reference voltages comprise a first reference voltage and a second reference voltage lower than the first reference voltage, and
wherein the comparison circuit comprises:
a first comparator configured to compare the first output voltage with the first reference voltage and to output a first output signal having a predetermined level as the selection signal in response to the first output voltage being higher than the first reference voltage; and
a second comparator configured to compare the first output voltage with the second reference voltage and to output a second output signal having the predetermined level as the selection signal in response to the first output voltage being lower than the second reference voltage.

5. The battery management system of claim 4, further comprising:
a first diode, an anode of which is connected to an output terminal of the first comparator; and
a second diode, an anode of which is connected to an output terminal of the second comparator,
wherein a cathode of the first diode and a cathode of the second diode are connected to an output terminal of the comparison circuit from which the selection signal is output.

6. The battery management system of claim 1, wherein the multiplexer comprises:
a first switch connected between a first input terminal to which the first output voltage is input and an output terminal;
a second switch connected between a second input terminal to which the second output voltage is input and the output terminal; and
a driver configured to drive the first switch and the second switch in response to the selection signal.

7. The battery management system of claim 1, wherein the first operational amplifier and the second operational amplifier are each connected in a form of a differential amplifier.

8. The battery management system of claim 1, further comprising:
a first resistor connected between the first terminal of the shunt resistor and a negative input terminal of the first operational amplifier;
a second resistor connected between the negative input terminal of the first operational amplifier and an output terminal of the first operational amplifier;
a third resistor connected between the second terminal of the shunt resistor and a positive input terminal of the first operational amplifier;
a fourth resistor connected between the positive input terminal of the first operational amplifier and a power source that supplies a predetermined voltage;
a fifth resistor connected between the first terminal of the shunt resistor and a negative input terminal of the second operational amplifier;
a sixth resistor connected between the negative input terminal of the second operational amplifier and an output terminal of the second operational amplifier;
a seventh resistor connected between the second terminal of the shunt resistor and a positive input terminal of the second operational amplifier; and
an eighth resistor connected between the positive input terminal of the second operational amplifier and the power source that supplies the predetermined voltage.

9. The battery management system of claim 8, wherein a ratio of resistances of the first resistor and the second resistor is equal to a ratio of resistances of the third resistor and the fourth resistor, and
wherein a ratio of resistances of the fifth resistor and the sixth resistor is equal to a ratio of resistances of the seventh resistor and the eighth resistor.

10. A battery apparatus, comprising:
a battery module;
a shunt resistor through which a current of the battery module flows;
a current measurement apparatus configured to
generate a first output voltage corresponding to the current flowing through the shunt resistor based on a first gain,
generate a second output voltage corresponding to the current flowing through the shunt resistor based on a second gain different from the first gain, and
select, as a measurement voltage, an output voltage from among a plurality of output voltages including the first output voltage and the second output voltage based on the first output voltage; and
a processor configured to determine the current flowing through the shunt resistor based on the measurement voltage of the current measurement apparatus.

11. The battery apparatus of claim 10, wherein the current measurement apparatus comprises:
an operational amplifier circuit configured to generate a first output voltage corresponding to the current flowing through the shunt resistor based on the first gain, and to generate a second output voltage corresponding to the current flowing through the shunt resistor based on the second gain;
a comparison circuit configured to generate a selection signal based on a result of comparing the first output voltage with one or more reference voltages; and
a multiplexer configured to select, as the measurement voltage, the output voltage from among the plurality of output voltages based on the selection signal.

12. The battery apparatus of claim 11, wherein the second gain is lower than the first gain.

13. The battery apparatus of claim 11, wherein the operational amplifier circuit comprises:
a first operational amplifier configured to amplify a difference between a voltage of a first terminal of the shunt resistor and a voltage of a second terminal of the shunt resistor based on the first gain to generate the first output voltage; and
a second operational amplifier configured to amplify the difference between the voltage of the first terminal of the shunt resistor and the voltage of the second terminal of the shunt resistor based on the second gain to generate the second output voltage.

14. The battery apparatus of claim 11, wherein the one or more reference voltages comprises a first reference voltage and a second reference voltage lower than the first reference voltage, and
wherein the comparison circuit comprises:
a first comparator configured to compare the first output voltage with the first reference voltage and to output, as the selection signal, a first output signal having a predetermined level in response to the first output voltage being higher than the first reference voltage; and
a second comparator configured to compare the first output voltage with the second reference voltage and to output, as the selection signal, a second output signal having the predetermined level in response to the first output voltage being lower than the second reference voltage.

15. The battery apparatus of claim 11, wherein the multiplexer is configured to:
select the second output voltage as the output voltage in response to the selection signal having the predetermined level, and
select the first output voltage as the output voltage in response to the selection signal not having the predetermined level.

16. The battery apparatus of claim 11, wherein the processor is further configured to receive the selection signal and the measurement voltage, and to determine the current flowing through the shunt resistor based on the selection signal and the measurement voltage.

17. A method of measuring a current of a battery apparatus, the method comprising:
receiving voltages of a first terminal and a second terminal of a shunt resistor formed in a path through which a current of a battery module flows;
amplifying a voltage between the first terminal and the second terminal based on a first gain to generate a first output voltage;
amplifying the voltage between the first terminal and the second terminal based on a second gain different from the first gain to generate a second output voltage; and
measuring the current flowing through the resistor based on the second output voltage in response to the first output voltage satisfying a predetermined condition.

18. The method of claim 17, further comprising measuring the current flowing through the resistor based on the first output voltage in response to the first output voltage not satisfying the predetermined condition.

19. The method of claim 17, wherein the predetermined condition comprises a condition that the first output voltage is higher than a first reference voltage or lower than a second reference voltage, and
wherein the second reference voltage is lower than the first reference voltage.
